# EUROPEAN PATENT SPECIFICATION

(11) **EP 2 647 050 B1**
(45) Date of publication and mention of the grant of the patent: **11.04.2018**
(21) Application number: 11810792.9
(22) Date of filing: 05.12.2011
(51) Int. Cl.: B82Y 10/00, H01L 51/00, H01L 27/30, H01L 51/42, H01L 51/44

(54) **METHOD FOR FORMING AN ELECTRICAL INTERCONNECTION IN AN ORGANIC PHOTOVOLTAIC DEVICE AND AN ORGANIC PHOTOVOLTAIC DEVICE MADE BY THE SAME**
VERFAHREN ZUR HERSTELLUNG EINER ELEKTRISCHEN VERSCHALTUNG IN EINER ORGANISCHEN PHOTOVOLTAISCHEN VORRICHTUNG UND EINE DAMIT HERGESTELLTE ORGANISCHE PHOTOVOLTAISCHE VORRICHTUNG
PROCÉDÉ DE FORMATION D'UNE INTERCONNEXION ÉLECTRIQUE DANS UN DISPOSITIF PHOTOVOLTAÏQUE ORGANIQUE, ET UN DISPOSITIF PHOTOVOLTAÏQUE ORGANIQUE FABRIQUÉ PAR LEDIT PROCÉDÉ

(30) Priority: 03.12.2010 EP 10193587
(43) Date of publication of application: 09.10.2013
(73) Proprietor: Novaled GmbH, 01307 Dresden (DE)
(72) Inventor: BLOCHWITZ-NIMOTH, Jan, 01097 Dresden (DE)
(74) Representative: Bittner, Thomas L.
(86) International application number: PCT/EP2011/006078
(87) International publication number: WO 2012/072271

(56) References cited:
- EP-A2- 0 320 089
- EP-A2- 1 596 446
- WO-A1-2010/044738
- WO-A2-2007/004115
- DE-A1-102008 050 332
- JP-A- 2011 124 231

## Description

The invention relates to a method for forming an electrical interconnection in an organic photovoltaic device and an organic photovoltaic device made by the same.

### Background of invention

Organic photovoltaics (OPV) offer a big promise for the efficient and large scale conversion of light into electricity. The production of organic photovoltaic devices is less material demanding than the production of inorganic crystalline photovoltaic devices. The production also consumes considerably less energy than the production of any other inorganic photovoltaic device.

Efficiency of organic photovoltaic devices has been improving steadily. In 2008 a certified power conversion efficiency value of 5% was reached, and in 2010 the psychological barrier of 8% was broken, aligning the efficiency of the organic photovoltaic devices to typical values of amorphous Si devices.

OPV devices comprise at least one solar cell, or an arrangement of solar cells. Organic solar cells have the most different layer stack architectures. Typically they comprise at least one organic photovoltaic layer between two electrodes. That organic layer can be a blend of a donor and an acceptor such as P3HT (Poly3-Hexyl-Thiophene) and PCBM (Phenyl C61 Butyric Acid Methyl Ester). Such simple device structures only achieve reasonably efficiencies if interfacial injection layers are used to facilitate charge carrier injection/extraction (Liao et al., Appl. Phys. Lett., 2008. 92: p. 173303). Other organic solar cells have multi-layer structures, sometimes even hybrid polymer and small molecule structures. Also tandem or multi-unit stacks are known (US7675057, or Ameri et al., Energy & Env. Science, 2009. 2: p. 347). Multi-layer devices can be easier optimized since different layers can comprise different materials which are suitable for different functions. Typical functional layers are transport layers, optically active layers, injection layers, etc.

Optically active materials are materials with a high absorption coefficient, for at least a certain wavelength range of the solar spectrum, which materials convert absorbed photons into excitons which excitons in turn contribute to the photocurrent. The optically active materials are typically used in a donor-acceptor heterojunction, where at least one of the donor or acceptor is the light absorbing material. The interface of the donor-acceptor heterojunction is responsible for separating the generated excitons into charge carriers. The heterojunction can be a bulk-heterojunction (a blend), or a flat (also called planar) heterojunction, additional layers can also be provided (Hong et al., J. Appl. Phys., 2009. 106: p. 064511).

The loss by recombination must be minimized for high efficiency OPV devices. Therefore, the materials in the heterojunction must have high charge carrier mobilities and high exciton diffusion lengths. The excitons have to be separated at the heterointerface and the charge carriers have to leave the optically active region before any recombination takes place. Currently, fullerenes (C60, C70, PCBM, and so on) are the preferred choice as acceptor in OPV devices.

Transport materials for transport layers for opto-electronic devices are required to be transparent, at least in the wavelengths wherein the device is active, and have good semiconducting properties. These semiconducting properties are intrinsic, such as energy levels or mobility, or extrinsic such as charge carrier density. The charge carrier density can also be influenced, for instance, by doping the material with an electrical dopant.

Although the current efficiency record for an organic solar cell is about 8%, this value is still much lower than the theoretical Shockley-Queisser limit applied to multiple tandem solar cells of 86%. For further increasing the efficiency, all loss mechanisms have to be taken into account, such as optical optimizations, optimization of excitonic transport and separation, electrical optimizations, etc. Still, when transferring a single solar cell into larger arrangements (called herein as OPV device), other losses occur due to increased series resistance. The series resistance is mainly due to the thin film electrodes used in an organic solar cell, very often due to the resistance of the transparent electrode, since the non-transparent one can be made thicker and hence more conductive. Organic solar cells with higher efficiency have lower currents and higher voltages, to reduce the effect of the series resistance. Such higher voltages are obtained by using multiple tandem solar cells as explained in US7675057. To realize a large area OPV device, usually individual solar cells are connected in series. The series connection has a drawback: the area, of the surface which is exposed to light, is reduced.

That area is necessary to provide the interconnection between top and bottom electrodes from adjacent devices. Such interconnections require several patterning steps.

The known patterning processes are complex and time demanding. Typically, shadow masks are used to define the evaporation pattern of the several layers. The alignment accuracy of the shadow mask defines the useful and clearly visible gap, between the organic solar cells.

Alternatively, if no fine masking is available, the gap between the organic solar cells will be very large (in the range of 1 mm and above).

An electrical interconnection between insulated segments of an organic electronic device by means of vias is disclosed in document WO 2007/004115 A2. The vias are formed by a laser applied through a substrate of the organic electronic device. to a functional layer of the organic electronic device.

WO 2010/044738 A1 discloses a method for manufacturing a thin film solar cell module, wherein an electrical interconnection between bottom and top conductive layers of the thin film solar cell module is provided by laser transforming a functional layer arranged between the conductive layers of the thin film solar cell module through the top conductive layer of the thin film solar cell module and then laser or stylus scribing at least the top conductive layer of the thin film solar cell module, or vice versa.

### Summary of the invention

A method for forming an electrical interconnection in an organic photovoltaic device according to claim 1, an organic photovoltaic device according to claim 8, and a use of an organic photovoltaic device according to claim 11 are disclosed.

The invention solves the problem of the prior art, providing an OPV device with series connected solar cells, having a reduced gap necessary for the connections. The invention also provides a method for producing such an OPV device, which method does not required the use of shadow masks for creating the series interconnection. According to the invention, the step of providing the electrical interconnection is preceded by the step of providing an encapsulation The laser light may be irradiated through the substrate or through the encapsulation, however the laser which does the electrical interconnection is irradiated through the encapsulation. In some cases, UV filters, or other layers (films) may be fabricated over the encapsulation. It is preferably that the deposition of these layers is performed after providing the electrical interconnection. The encapsulation may be a glass cover or thin film encapsulation. It is necessary that the encapsulation does not absorb the laser light (Absorbance < 2%). A highly transparent encapsulation, with a transmittance > 95% to the wavelength of the laser being used is preferred. The electrical interconnection is made by a laser process, in which step vacuum or inert atmosphere are not required.

In a preferred embodiment, the step of providing the electrical interconnection comprises providing several aligned interconnections. The aligned interconnections are electrical interconnections made consecutively in a line which can be a straight line or a curve, the electrical interconnections can be merged or spaced apart from each other. The aligned interconnections can consist of several spot sized electrical interconnections aligned in a straight or curved line.

Optionally the aligned interconnections are more than one line in parallel such as double or triple aligned interconnections. At least one of the organic photovoltaic layer and the second conductive layer, and preferably both layers, may be formed on the substrate by a maskless deposition process comprising a step of maskless depositing materials in at least an active area of the organic photovoltaic device. In a preferred embodiment, for a method of producing an OPV device comprising a plurality of organic solar cells, the method includes providing a substrate, and providing a first conductive layer on the substrate. The first conductive layer may be patterned by any known method.

Preferentially the step of providing a first conductive layer includes:
- depositing a first conductive layer on a substrate;
- patterning the first conductive layer by laser.
In the patterning the first conductive layer step, parts of the first conductive layer are removed, forming at least two electrically isolated areas spaced by narrow gaps, first and second sections of the first conductive layer. This step is preferentially performed with laser ablation to ensure that the gaps are very narrow.

Known lasers can be used for the sectioning step, which is applied to the first conductive layer or the second conductive layer (or to both). For instance, a table top laser from ACI Laser-components can be used. Preferentially, the step of patterning the first conductive layer by laser is performed before the step of providing an organic photovoltaic layer. This can easily be done since this step could be performed outside of the process equipment for the remaining layers (especially the organic photovoltaic layer) and careful cleaning of the patterned first conductive layer may still be provided to remove remaining particles from the laser ablation step.

In an advanced mode of the invention, in the method for forming an electrical interconnection in an organic photovoltaic device, the step of providing an electrical interconnection includes the steps of:
- electrically interconnecting the first section of the first conductive layer with the second conductive layer; and
- sectioning the second conductive layer into a first section of the second conductive layer and a second section of the second conductive layer, wherein the first section of the second conductive layer is electrically short disconnected from the first section of the first conductive layer and the second section of the second conductive layer is electrically short connected to the first section of the first conductive layer.

Forming the electrical interconnection with a laser requires that the laser does not ablate the layers; therefore it is preferable that the laser power is lower than the power used for ablation. It is further preferable that the power of the laser is between 200mW and 15 W, more preferably between 200mW and 5 W, for an infrared laser with a wavelength between 800 and 10 µm; for a laser with shorter wavelengths in the range of 300 to 800 nm, it is preferred that the power is between 200 mW and 3 W, more preferably from 200 mW to 1 W, even more preferably from 200 to 500 mW.

The laser emission can be between 300 and 550 nm, especially in the range between 300 and 450 nm; in these ranges, the absorption of the metal layer is stronger, and it is easier to promote a heating. Any laser can be used, such as tripled or quadrupled Nd lasers, excimer lasers, or semiconducting lasers. Non limiting examples of such short wavelength lasers are InGaN blue-violet lasers, tripled Nd:YAG lasers, and XeF excimer lasers. The laser used for the electrical interconnection can also have a wavelength from 500 to 1500 nm. Exemplary lasers are Nd lasers operating in their main wavelength which is typically in the range of 1020-1050 nm, however other modes as well as the double frequency can be used. Examples of such lasers are Nd:YAG lasers at 1064 nm or 532 nm; Nd:YVO₄ lasers at 914, 1064 or 1342 nm; and Nd:YLF lasers at 1047 or 1053 nm.

Other wavelengths and power values can also be used, a calibration step can be necessary to find the optimum configuration of the laser.

Gas and excimer lasers can also be used, as well as semiconductor or fiber lasers. The laser can also match the absorption of a transparent oxide layer (if such is used as first or second conductive layer); it can also match an absorption wavelength of an organic semiconductive layer. Preferentially, pulsed lasers are used which make it easier to control the laser power per shot, which shot is forming the electrical interconnection.

For a diode-pumped Nd:YAG (1064 nm), ns Q-switched laser, good results were obtained using pulses with an energy higher or equal to 10µJ. About 1000 shots at 10µJ do deliver a good contact.

With a ps diode-pumped Nd:YAG (1064 nm), Q-switched laser by Pockels cell, best results were obtained at power above 300mW. Tested repetition rates were between 10 kHz and 640 kHz.

In an advanced alternative mode of the invention, in the method for forming an electrical interconnection in an organic photovoltaic device, the step of providing an electrical interconnection includes the steps of:
- sectioning the second conductive layer into a first section of the second conductive layer and a second section of the second conductive layer; and
- electrically interconnecting the first section of the first conductive layer with the second section of the second conductive layer. According to the invention, the step of providing the electrical interconnection is made after the step of providing the encapsulation. The invention also foresees an OPV device made by a method as described above, the device comprising a substrate, a first conductive layer, a second conductive layer, and a string of in-series connected organic solar cells on the substrate, wherein the series connection of the in-series connected organic solar cells comprises electrical interconnections between the first conductive layer of a first organic solar cell and the second conductive layer of a second organic solar cell, and wherein the organic photovoltaic device is a large-area device having an area of more than about 25 cm². The electrical interconnections are formed by a laser process, namely the irradiation of light into a connection area in which the electrical interconnections are to be formed. The material modification generated by the laser process laser may be, for example, a molten material, a re-solidified material, or other. The electrical interconnections can be recognized by their typical shape formed by the high energy density of the laser. Preferentially, the electrical interconnections are a punctual connection (dot like).

In a large area device, the electrical interconnections need to provide enough conductivity to transport larger current densities, therefore, the electrical interconnections form a plurality, preferentially a plurality of dots, which dots may be spaced apart from each other or merged to each other. Optionally, the device comprises multiple strings. A calibration step can be introduced to calibrate the laser parameters before performing the interconnection step.

In one embodiment of the invention, the OPV device comprising a string of in-series connected organic solar cells further comprises electrical terminals at the string's ends.

In another embodiment of the invention, the OPV device comprising a string of in-series connected organic solar cells further comprises another string of in-series connected organic solar cells, which first and second strings of in-series connected organic solar cells are connected in parallel by electrically connecting their positive terminals to a common terminal, and electrically connecting their negative terminals to another common terminal. This embodiment also foresees multiple strings connected in parallel, wherein each string is a string of organic solar cells connected in series.

Preferably the OPV device in all embodiments is a very large area device. The area of the OPV device is larger than about 25 cm², preferentially larger than about 100 cm². Each individual organic solar cell is preferentially larger than 1 cm².

An advantage of the invention is the realization of large area OPV devices comprising arrays of organic solar cells connected together, with maximum area utilization.

Another advantage is the maskless production process, which enhances production efficiency, reducing maintenance, material consumption, calibration complexity, and considerably increasing the output-speed. The invention consequently also increases the production yield.

Further the production tool complexity is reduced; in the special case of production with VTE or organic vapor phase deposition, the deposition chamber is simplified and can be limited to the deposition of continuous layers. The present invention also does not require the use of moving shadow masks during deposition of the layers.

The invention is preferably used in web production methods, such as roll-to-roll processing.

An especial feature of the invention is the use of the OPV devices, produced with the inventive method, in a window for a building. Such applications are also known as building integrated photovoltaics, where, especially in windows and glass façades, semi-transparent OPV devices can be used; OPV devices with no (or almost no) visible patterns give the optical impression of a smooth optical coating.

### Summary of the figures

In the following, the invention will be described in further detail, by the way of example, with reference to different embodiments. The figures show:
Fig. 1 a flow chart of a method for forming a device with an organic photovoltaic layer and an electrical interconnection, according to the prior art,
Fig. 2 a flow chart of a method of producing an OPV device comprising at least two, in series connected organic solar cells, according to the prior art, Fig. 3a an OPV device according to the prior art without electrical interconnections, Fig. 3b the device of Fig. 3a after the sectioning of the second conductive layer is performed,
Fig. 3c the device of Fig. 3b after the electrical interconnections are formed,
Fig. 4 a top view schematic of an OPV device according to the prior art comprising series connected organic solar cells,
Fig. 5 a top view schematic of an OPV device according to the prior art comprising series connected organic solar cells, Figs. 6a-c the production of an exemplary embodiment of the invention, and
Fig. 7 a schematic showing the equipment and the individual steps for the production of an OPV device on a web substrate according to an example falling outside the scope of the appended claims. The figures are only schematic representations, and are not to scale. Especially in Figs. 3a-c, the layer thickness is not to scale, as the substrate is usually much thicker than the other layers. Also the electrical interconnections and the borders of the layers normally do not form a right angle.

### Embodiments

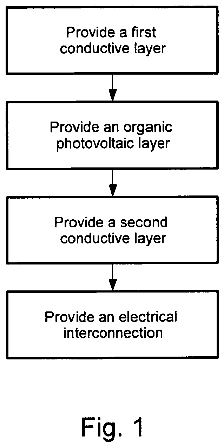

Fig.1 shows a flow chart of method of producing an OPV device according to the prior art, the method comprising the steps of providing a first conductive layer, which is provided on a substrate, providing an organic photovoltaic layer over the first conducting layer, providing a second conductive layer over the organic photovoltaic layer, and providing an electrical interconnection between the first and second conductive layers. As shown in the figure, the electrical interconnection is provided after the deposition of the second conductive layer.

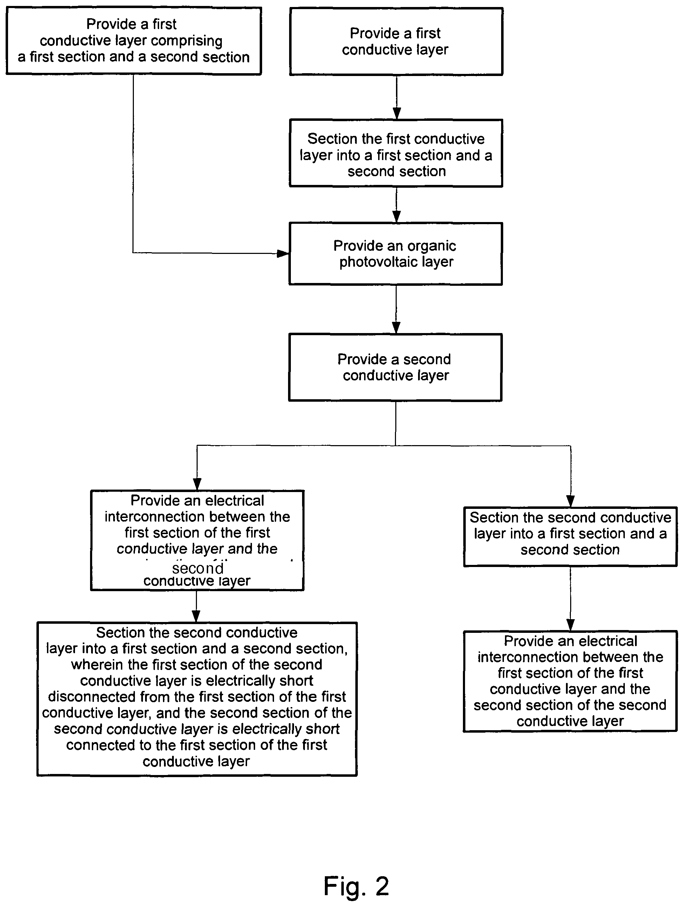

Fig. 2 shows a flow chart of a method of producing an OPV device according to the prior art, comprising at least two, preferentially several, individual organic solar cells connected in series. The method comprises the step of providing a first conductive layer on a substrate, and the step of sectioning the first conductive layer patterned into at least first and second sections of the first conductive layer, alternatively the first conductive layer can be provided into at least first and second sections of the first conductive layer. The at least first and second sections of the first conductive layer are used to form the bottom electrodes of the organic solar cells, which organic solar cells will be connected in series. Fig. 2 shows that an organic photovoltaic layer is provided on the first conductive layer. This organic photovoltaic layer is provided in an essentially patterned way, meaning that it is a closed and continuous layer. A second conductive layer is provided over the organic photovoltaic layer. After the deposition of the second conductive layer, the following steps are provided to connect the individual organic solar cells in series, which steps can also be executed in reverse order: (i) the second conductive layer is sectioned into at least first and second sections of the second conductive layer. The sections of the second conductive layer also provide the top electrodes for the organic solar cells. The sections effectively separate the top electrodes of the individual organic solar cells from each other; (ii) An electrical interconnection is formed between the first section of the first conductive layer and the second section of the second conductive layer.
The electrical interconnection electrically connects the top electrode of an organic solar cell to the bottom electrode of an adjacent organic solar cell providing an electrical series connection.

Still on the method of Fig. 2, the steps of sectioning the second conductive layer and creating the electrical interconnection can be made under similar conditions as used for the deposition of the organic photovoltaic layer, e.g. under high vacuum. However, it is preferred that these steps are made under more relaxed conditions, preferably under inert gas atmosphere, in atmosphere (air), or under a flux of protective gas. Under such conditions, it is easier to remove possible waste materials with minimum contamination, of e.g. a vacuum chamber, and it is easier to manage the scanning laser process needed to create many electrical interconnections. According to the invention, an encapsulation is provided before the step of creating an electrical interconnection. This enables the electrical interconnection to be made under relaxed conditions, for instance, in air. In air, it is easier to handle laser positioning and there is no generation of waste material outside the encapsulation.
The encapsulation can be, for example, a glass lid with an air-gap, laminated foil, edge glued foil, or a direct thin film encapsulation.

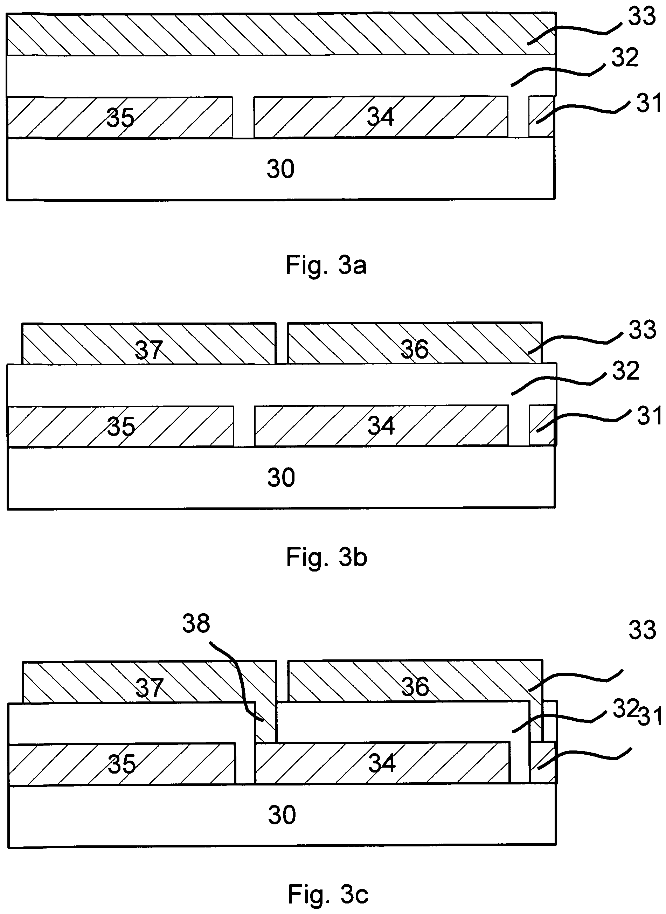

Fig. 3a shows an OPV device according to the prior art, comprising a first conductive layer 31 on a substrate 30, an organic photovoltaic layer 32, and a second conductive layer 33. The first conductive layer 31 comprises a first section 34 of the first conductive layer 31 and a second section 35 of the first conductive layer 31. After the step of patterning the second conductive layer 33 into a first section 36 of the second conductive layer 33 and a second section 37 of the second conductive layer 33, the device can be represented schematically by Fig. 3b. In Fig. 3b, the individual organic solar cells are defined by the overlapping of the second section 37 of the second conductive layer 33 and the second section 35 of the first conductive layer 31, and the overlapping of the first section 34 of the first conductive layer 31 and the first section 36 of the second conductive layer 33. The electrical interconnection 38 is demonstrated in Fig. 3c. Here the second section 37 of the second conductive layer 33 is electrically connected to the first section 34 of the first conductive layer 31. Effectively, the electrical interconnection 38 is a low resistance electrical connection between the first and second conductive layers 31, 33. While the layer configuration depicted in Fig.3a preceeds the steps of interconnecting (Fig. 3c) and sectioning the second conductive layer (Fig. 3b), the last two steps can be performed in reverse order.

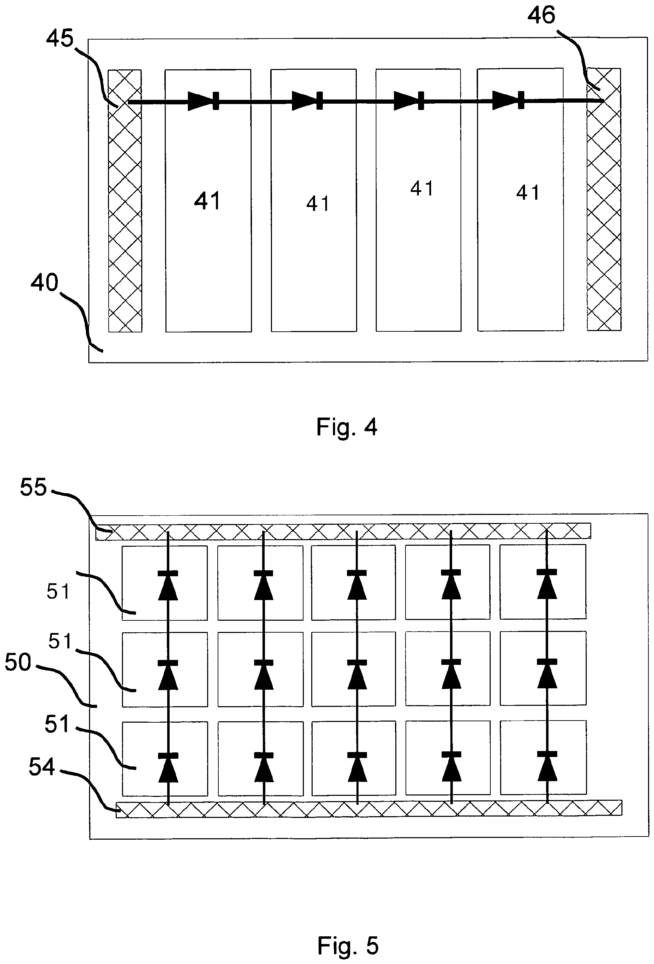

Fig. 4 shows a schematic of an OPV device according to the prior art, comprising a substrate 40, a string of organic solar cells 41 connected in series, and first and second end-connections 45, 46. Symbols of diodes overlap the OPV device to enhance the representation of the string of series connected organic solar cells 41. The individual organic solar cells 41 are represented by their active areas. The sectioning of the conductive layers and the electrical interconnections (see Figs. 3a-c for details) are formed in the spaces between the adjacent organic solar cells. At least one of the first and second end connections 45, 46 can comprise or be made of an extension of the first conductive layer or the second conductive layer. The schematic of Fig. 4 can be, for instance, made from a web substrate, such as a continuous sheet of paper, metal, or polymer. The orientation of the web can be parallel to the longest sides of the rectangle representing the substrate 40. Alternatively, for wide webs, the orientation of the web can be parallel to the shortest sides of the rectangle representing the substrate 40.

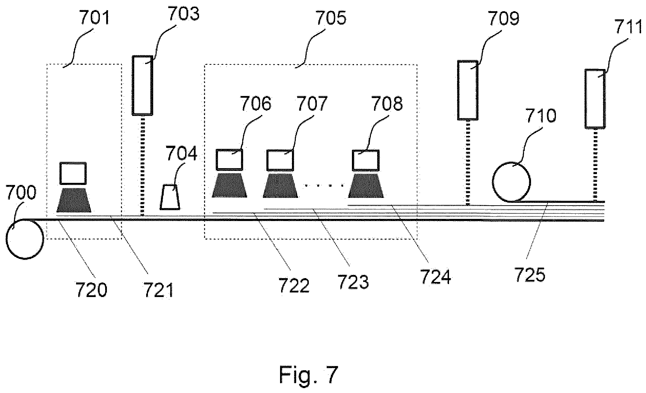

Fig. 5 shows a schematic of an OPV device according to the prior art, comprising a substrate 50 and multiple strings connected in parallel. Each string comprises organic solar cells connected in series. A first string of organic solar cells connected in series is represented by organic solar cells 51 and two first and second end connections 54, 55. Symbols of diodes overlap the OPV device to enhance the representation of the strings of series connected organic solar cells. The individual organic solar cells are represented by their active areas. The sectioning of the conductive layers and the electrical interconnections (see Figs. 3a-c for details) are formed in the spaces between the adjacent organic solar cells. At least one of the first and second end connections 54, 55 can comprise or be made of an extension of the first conductive layer or the second conductive layer. The schematic of Fig. 5 can be, for instance, made from a web substrate, such as a continuous sheet of paper, metal, or polymer. The orientation of the web can be parallel to the longest sides of the rectangle representing the substrate 50. With this embodiment it is possible to provide an OPV device with a higher voltage without requiring very long series connection of large area organic solar cells. This embodiment further has the advantage that each string of in series connected organic solar cells can be made sufficiently narrow, and cut out of the circuit in case of a defect, by sectioning at least one of the first conductive layer or the second conductive layer. Another advantage is, for a web production (e.g. roll-to-roll) the roll can be cut at any desired length to provide OPV devices with differentiated lengths, while the end connections are always available. While the OPV device has an increased number of individual organic solar cells, it does not have any noticeable loss in power performance, due to the very precise sectioning and electrical interconnections, which consume an irrelevant area. Fig. 7 shows the fabrication of an OPV device on a web substrate according to an example falling outside the scope of the appended claims. The web substrate 720 is fed from a first roll 700, into a first deposition tool 701 for deposition of a first conductive layer 721. After the deposition of the first conductive layer 721 on the web substrate 720, the first conductive layer 721 is sectioned by a means 703 which is preferably a laser. The first conductive layer 721 can be patterned into complex patterns by means 703, because the laser allows it to be made in a very simple manner. After the sectioning step by means 703, the substrate and the first conductive layer 721 are cleaned by cleaning means 704. The sectioning with the means 703 and cleaning is preferably done outside of the first deposition tool 701, and outside of a second deposition tool 705. Alternatively the first roll 700 already comprises a substrate with a sectioned first conductive layer.

Still on Fig. 7, the web substrate is fed into the second deposition tool 705, which is preferably a vacuum tool for deposition of layers via VTE, in which second deposition tool 705 organic photovoltaic layers are deposited. The second deposition tool 705 comprises first and second sources 706, 707, etc. for deposition of first and second organic photovoltaic layers 722, 723, etc. A second conductive layer 724 is deposited after the deposition of the first and second organic photovoltaic layers 722, 723, etc. by a third source 708 which may be in the same second deposition tool 705 or in a separated tool. The second conductive layer 724 is sectioned by a first laser 709, after the deposition of the second conductive layer 724, which sectioning is preferably made outside of the second deposition tool 705, and preferably in an inert atmosphere (not shown). The OPV device is encapsulated with an encapsulation 725 which can be, for example, a foil from a second roll 710 laminated on the device; the encapsulation is done after the sectioning of the second conductive layer 724. The electrical interconnection is provided on the OPV device with a second laser 711 after the encapsulation.

The first and second deposition tools 701 and 705 could be integral part of the same deposition tool. Also the cleaning step can take place inside the tool, for instance also in low or high vacuum.

The cleaning means 704 can be, for example, plasma etching, mechanical, chemical or chemical-mechanical polishing, brushing or other equivalent means.

Following additional information on terms used is provided.

A substrate can be a rigid or flexible substrate; it can be preferentially a metal layer, a glass plate, a polymer foil, paper, or a web of one of these materials or their combinations.

A web substrate has the common technical meaning, examples of such substrates are such as a continuous sheet of paper, metal, or polymer. An encapsulation is a moisture and oxygen barrier layer, non-limiting examples of which are a glass cover, a metal cover, thin oxide or nitride films, a thin film encapsulation with a multilayer stack, laminated foils, edge glued foils, a combination of these, etc.. An organic photovoltaic (OPV) device is an electrical device capable of transforming light into electricity. An OPV device is comprised of at least one organic solar cell, preferably several organic solar cells. An individual organic solar cell, or simply an organic solar cell, is a single device (typically a diode) comprising two electrodes and an organic photovoltaic layer. Sectioning herein means to divide; to section a layer into sections, or means to pattern the layer in such a way that electrically disconnected sections (or areas) are formed. An organic photovoltaic layer is an organic semiconductive layer used for an organic solar cell as known in the prior art. It comprises at least a donor-acceptor heterojunction, where at least one of the donor or acceptor materials is a light absorbing material. The organic photovoltaic layer can further comprise other layers with functions such as transport, injection, and connecting units.

Interconnection and electrical interconnection are used as synonyms. The interconnection provided by a laser is an electrical interconnection between two electrically conductive layers made with a laser through an organic photovoltaic layer. The electrical interconnection is made after the deposition of the two electrically conductive layers and the organic photovoltaic layer, where the laser treatment promotes a local, low resistance, electrical contact between the two electrically conductive layers.

Since a carbonization of the organic material is not expected, it is believed that the electrical interconnection is a direct connection of both layers, created by locally disrupting the organic semiconductor layer. Interconnection in series or electrical interconnection in series is one kind of electrical interconnection.

Maskless (or essentially maskless) deposition is a deposition method, wherein the deposition area of a layer is defined by a shadow mask which defines only the limiting external borders of the layer, the shadow mask having an opening (a through-hole) which is defined by one close geometric shape, which can be convex or concave, preferentially convex, more preferentially a rectangular, closed conic section, or other closed curved shape. A non limiting example is a rectangular frame with one rectangular opening, the one rectangular opening defining the deposition area of a layer over a whole substrate. Except for the borders, which need to be isolated, there is no further structure. In a continuous production process, such as a roll-to-roll process, the outer limitation of layers can be defined by avoiding deposition at the lateral areas of the roll (or web), defining something like a margin.

### Example

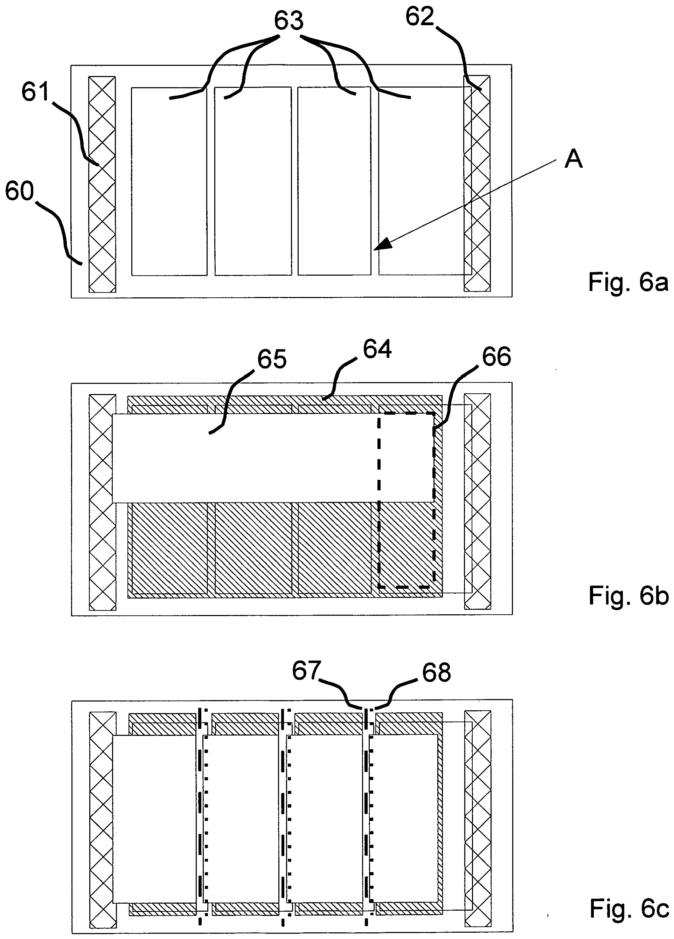

The following example will be explained in conjunction with Figs. 6a-c. An OPV device was made on a substrate 60 that is a glass substrate. The substrate 60 was provided with two first and second conductive areas 61, 62 for external electrical connections. On the substrate 60, a first conductive layer was provided, made by reactive sputtering a 90 nm thick layer of indium-tin-oxide (ITO), which first conductive layer was then sectioned (patterned) with a laser forming 4 rectangular sections 63. Region A indicates one region were the layer was sectioned. One of these sections (most right in Fig. 6a) overlaps with the second conductive area 62. The laser used in the sectioning step was a pulsed Nd:YAG laser operating at 1064 nm configured at 400mW, 10 ms dwell-time, pulse duration of 8 ps. The substrate was moved into high vacuum, where an organic photovoltaic layer, represented by the dashed area 64, was deposited with the following layers:
- 5 nm of fullerene C₆₀;
- 20 nm of a bulk heterojunction comprising C₆₀:ZnPc (molar ratio 2:1), were ZnPc is zinc phthalocyanine;
- 5 nm N,N' - diphenyl - N,N' - bis (4'- (N,N- bis (naphtha - 1 - yl) amino) - biphenyl - 4 - yl) - benzidine (DiNPB)
- 50 nm of DiNPB doped with 2,2'-(perfluoronaphthalene-2,6-diylidene)dimalononitrile (2mol%);
- 10 nm of ZnPc doped with 2,2'-(perfluoronaphthalene-2,6-diylidene)dimalononitrile (4mol%); A second conductive layer, namely a 100 nm thick Au:Ag (atomic ratio 1:1) layer, represented by the rectangle 65, was deposited on top of the organic photovoltaic layer. Only the upper half of the second conductive layer is shown, to explicitly show that the organic photovoltaic layer is unpatterned. The second conductive layer is also unpatterned, at this stage. The substrate was taken out of the vacuum chamber and stored in a glove box filled with nitrogen.

In the glovebox, after the providing of the organic photovoltaic layer and the second conductive layer, a glass encapsulation is provided, by glueing a glass cover to the substrate using a light curing sealant XNR5516 (Nagase). The glass cover contained moisture and oxygen getter adhesives in its interior. Thin film encapsulation, such as a multilayer barrier could have been provided instead of a glass cover.

The OPV device was almost completed, still requiring a serial connection. For that purpose, the substrate was taken out of the glove box and the electrical interconnection between the first and second conductive layers and the sectioning of the second conductive layers were performed. Although the order of the steps of electrical interconnection and sectioning are not relevant, the following procedure was performed for the purpose of measuring the quality of the electrical interconnections At this stage, the external electrical connections can be used to measure the quality of the sectioning and of the electrical interconnection. An open circuit voltage of 0,55 V was measured at the external electrical connections, the active organic solar cell is defined by the area 66. After sectioning the second conductive layer by laser ablating a line (Fig. 6c, dashed line 67), the measured resistance (both polarities, bias = 1 V), was indicated as infinity (open circuit), proving that the second conductive layer was successfully sectioned into two sections. The laser used in the sectioning step was a pulsed Nd:YAG laser operating at 1064 nm configured at 400mW, 10 ms dwell-time, pulse duration of 8 ps. The electrical interconnection was performed at the dotted line 68, making a series connection of the two most right organic solar cells. After the electrical interconnection step, an open circuit voltage of 1,1 V was measured at the external electrical connections. The laser used in the electrical interconnecting step was a pulsed Nd:YAG laser operating at 1064 nm configured at 400mW, 10 ms dwell-time, pulse duration of 8 ps. The laser was firstly calibrated by measuring the resistance between two conductive layers, before and after an electrical interconnection, in calibration samples made with the same layer stack configuration as the OPV device. The calibration could also have been performed on the OPV device directly, or the calibration data could have been pre-programmed in the equipment comprising the laser. After finishing all sectioning steps (Fig. 6c, dashed lines) and all electrical interconnections (Fig. 6c, dotted lines), an open circuit voltage of 2.2 V was measured.

Other lasers were also tested, and the parameters for each different laser could be easily adjusted to provide the electrical interconnection.

## Claims

1. A method for forming an electrical interconnection in an organic photovoltaic device, the method comprising the steps of:
- providing a first conductive layer on a substrate (60),
- providing an organic photovoltaic layer (64) over the first conductive layer,
- providing a second conductive layer (65) over the organic photovoltaic layer (64), and
- providing an electrical interconnection between the first conductive layer and the second conductive layer (65), **characterized in that** the method further comprises a step of providing an encapsulation after the step of providing the second conductive layer (65) and before the step of providing the electrical interconnection, and that the step of providing the electrical interconnection is performed by a laser applied through the encapsulation.

2. Method according to claim 1, wherein the step of providing the electrical interconnection comprises providing several aligned interconnections.

3. Method according to any one of the preceding claims, wherein the step of providing the organic photovoltaic layer (64) and the step of providing the second conductive layer (65) comprise at least one of the organic photovoltaic layer (64) and the second conductive layer (65) being formed on the substrate (60) by a maskless deposition process comprising a step of maskless depositing materials in at least an active area of the organic photovoltaic device.

4. Method according to any one of the preceding claims, wherein the step of providing the first conductive layer comprises providing the first conductive layer with a first section of the first conductive layer and a second section of the first conductive layer.

5. Method according to any one of the claims 1 to 3, wherein, before the step of providing an organic photovoltaic layer (64), the first conductive layer is sectioned into a first section of the first conductive layer and a second section of the first conductive layer.

6. Method according to any one of the claims 4 or 5, wherein the step of providing the electrical interconnection consists of:
- electrically interconnecting the first section of the first conductive layer with the second conductive layer (65), and
- sectioning the second conductive layer (65) into a first section of the second conductive layer and a second section of the second conductive layer, wherein the first section of the second conductive layer (65) is electrically short disconnected from the first section of the first conductive layer and the second section of the second conductive layer (65) is electrically short connected to the first section of the first conductive layer.

7. Method according to any one of the claims 4 or 5, wherein the step of providing the electrical interconnection consists of:
- sectioning the second conductive layer (65) into a first section of the second conductive layer (65) and a second section of the second conductive layer (65), and
- electrically interconnecting the first section of the first conductive layer with the second section of the second conductive layer (65).

8. An organic photovoltaic device made by the method for forming an electrical interconnection in an organic photovoltaic device according to any one of the claims 6 or 7, comprising: a substrate (60) and a string of in series connected organic solar cells on the substrate (60), wherein the series connection of the in series connected organic solar cells comprises electrical interconnections between the first conductive layer of a first organic solar cell and the second conductive layer (65) of a second organic solar cell, and wherein the organic photovoltaic device is a large area device having an area of more than about 25 cm².

9. Organic photovoltaic device according to claim 8, wherein the string of in series connected organic solar cells comprises electrical terminals at its ends.

10. Organic photovoltaic device according to any one of the claims 8 or 9, wherein the string of in series connected organic solar cells is a first string of in series connected organic solar cells, and the organic photovoltaic device further comprises a second string of in series connected organic solar cells electrically connected in parallel to the first string of in series connected organic solar cells.

11. A use of the organic photovoltaic device according to any one of the claims 8 to 10 in a window for a building.

## Patentansprüche

1. Verfahren zum Bilden einer elektrischen Verbindung in einer organischen Fotovoltaik-Vorrichtung, wobei das Verfahren die folgenden Schritte umfasst:
- Bereitstellen einer ersten leitfähigen Schicht auf einem Substrat (60),
- Bereitstellen einer organischen fotovoltaischen Schicht (64) über der ersten leitfähigen Schicht,
- Bereitstellen einer zweiten leitfähigen Schicht (65) über der organischen fotovoltaischen Schicht (64), und
- Bereitstellen einer elektrischen Verbindung zwischen der ersten leitfähigen Schicht und der zweiten leitfähigen Schicht (65),
**dadurch gekennzeichnet, dass** das Verfahren ferner einen Schritt des Bereitstellens einer Verkapselung nach dem Schritt des Bereitstellens der zweiten leitfähigen Schicht (65) und vor dem Schritt des Bereitstellens der elektrischen Verbindung umfasst, und dadurch, dass der Schritt des Bereitstellens der elektrischen Verbindung durch einen Laser ausgeführt wird, der durch die Verkapselung angewendet wird.

2. Verfahren nach Anspruch 1, wobei der Schritt des Bereitstellens der elektrischen Verbindung das Bereitstellen von mehreren ausgerichteten Verbindungen umfasst.

3. Verfahren nach einem der vorherigen Ansprüche, wobei der Schritt des Bereitstellens der organischen fotovoltaischen Schicht (64) und der Schritt des Bereitstellens der zweiten leitfähigen Schicht (65) das Bilden wenigstens einer der organischen fotovoltaischen Schicht (64) und der zweiten leitfähigen Schicht (65) auf dem Substrat (60) durch einen maskenfreien Abscheidungsprozess umfassen, der einen Schritt des maskenfreien Abscheidens von Materialien in mindestens einem aktiven Bereich der organischen fotovoltaischen Vorrichtung umfasst.

4. Verfahren nach einem der vorherigen Ansprüche, wobei der Schritt des Bereitstellens der ersten leitfähigen Schicht das Bereitstellen der ersten leitfähigen Schicht mit einem ersten Abschnitt der ersten leitfähigen Schicht und einem zweiten Abschnitt der ersten leitfähigen Schicht umfasst.

5. Verfahren nach einem der Ansprüche 1 bis 3, wobei vor dem Schritt des Bereitstellens einer organischen fotovoltaischen Schicht (64) die erste leitfähige Schicht in einen ersten Abschnitt der ersten leitfähigen Schicht und einen zweiten Abschnitt der ersten leitfähigen Schicht geteilt wird.

6. Verfahren nach einem der Ansprüche 4 oder 5, wobei der Schritt des Bereitstellens der elektrischen Verbindung besteht aus:
- dem elektrischen Verbinden des ersten Abschnitts der ersten leitfähigen Schicht mit der zweiten leitfähigen Schicht (65), und
- dem Teilen der zweiten leitfähigen Schicht (65) in einen ersten Abschnitt der zweiten leitfähigen Schicht und einen zweiten Abschnitt der zweiten leitfähigen Schicht, wobei der erste Abschnitt der zweiten leitfähigen Schicht (65) zum ersten Abschnitt der ersten leitfähigen Schicht nicht elektrisch kurzgeschlossen wird, und der zweite Abschnitt der zweiten leitfähigen Schicht (65) mit dem ersten Abschnitt der ersten leitfähigen Schicht elektrisch kurzgeschlossen wird.

7. Verfahren nach einem der Ansprüche 4 oder 5, wobei der Schritt des Bereitstellens der elektrischen Verbindung besteht aus:
- dem Teilen der zweiten leitfähigen Schicht (65) in einen ersten Abschnitt der zweiten leitfähigen Schicht (65) und einen zweiten Abschnitt der zweiten leitfähigen Schicht (65), und
- dem elektrischen Verbinden des ersten Abschnitts der ersten leitfähigen Schicht mit dem zweiten Abschnitt der zweiten leitfähigen Schicht (65).

8. Organische fotovoltaische Vorrichtung, die durch das Verfahren zum Bilden einer elektrischen Verbindung einer der organischen Fotovoltaik-Vorrichtung nach einem der Ansprüche 6 oder 7 hergestellt wird, umfassend:
ein Substrat (60) und eine Reihe von in Reihe verbundenen organischen Solarzellen auf dem Substrat (60),
wobei die Reihenschaltung der in Reihe verbundenen organischen Solarzellen elektrische Verbindungen zwischen der ersten leitfähigen Schicht einer ersten organischen Solarzelle und der zweiten leitfähigen Schicht (65) einer zweiten organischen Solarzelle umfasst, und
wobei die organische Fotovoltaik-Vorrichtung eine großflächige Vorrichtung ist, die eine Fläche von mehr als etwa 25 cm² hat.

9. Organische Fotovoltaik-Vorrichtung nach Anspruch 8, wobei die Reihe von in Reihe verbundenen organischen Solarzellen elektrische Anschlüsse an ihren Enden umfasst.

10. Organische Fotovoltaik-Vorrichtung nach einem der Ansprüche 8 oder 9, wobei die Reihe von in Reihe verbundenen organischen Solarzellen eine erste Reihe von in Reihe verbundenen organischen Solarzellen ist, und die organische Fotovoltaik-Vorrichtung ferner eine zweite Reihe von in Reihe verbundenen organischen Solarzellen umfasst, die elektrisch parallel zur ersten Reihe von in Reihe verbundenen organischen Solarzellen verbunden ist.

11. Verwendung der organischen Fotovoltaik-Vorrichtung nach einem der Ansprüche 8 bis 10 in einem Fenster für ein Gebäude.

## Revendications

1. Procédé de formation d'une interconnexion électrique dans un dispositif photovoltaïque organique, le procédé comprenant les étapes consistant à :
- former une première couche conductrice sur un substrat (60),
- former une couche photovoltaïque organique (64) située sur la première couche conductrice,
- former une seconde couche conductrice (65), située sur la couche photovoltaïque organique (64), et
- former une interconnexion électrique entre la première couche conductrice et la seconde couche conductrice (65),
**caractérisé en ce que** le procédé comprend en outre une étape consistant à former une encapsulation après l'étape consistant à former la seconde couche conductrice (65) et avant l'étape consistant à former l'interconnexion électrique, et **en ce que** l'étape consistant à former l'interconnexion électrique est effectuée au moyen d'un laser appliqué à travers l'encapsulation.

2. Procédé selon la revendication 1, dans lequel l'étape consistant à former l'interconnexion électrique consiste à former de nombreuses interconnexions alignées.

3. Procédé selon l'une quelconque des revendications précédentes, dans lequel l'étape consistant à former la couche photovoltaïque organique (64) et l'étape consistant à former la seconde couche conductrice (65) comprennent au moins une couche de la couche photovoltaïque organique (64) et de la seconde couche conductrice (65), étant formée sur le substrat (60) au moyen d'un processus de dépôt sans masque comprenant une étape consistant à déposer des matériaux sans masque d'en au moins une zone active du dispositif photovoltaïque organique.

4. Procédé selon l'une quelconque des revendications précédentes, dans lequel l'étape consistant à former la première couche conductrice consiste à former la première couche conductrice avec un premier segment de la première couche conductrice et un second segment de la première couche conductrice.

5. Procédé selon l'une quelconque des revendications 1 à 3, dans lequel, avant l'étape consistant à former une couche photovoltaïque organique (64), la première couche conductrice est segmentée en un premier segment de la première couche conductrice et en un second segment de la première couche conductrice.

6. Procédé selon l'une quelconque des revendications 4 ou 5, dans lequel l'étape consistant à former l'interconnexion électrique consiste à :
- interconnecter de manière électrique le premier segment de la première couche conductrice avec la seconde couche conductrice (65), et
- segmenter la seconde couche conductrice (65) en un premier segment de la seconde couche conductrice et en un second segment de la seconde couche conductrice, dans lequel le premier segment de la seconde couche conductrice (65) est électriquement court-circuité à partir du premier segment de la première couche conductrice et le second segment de la seconde couche conductrice (65) est électriquement court-circuité au premier segment de la première couche conductrice.

7. Procédé selon l'une quelconque des revendications 4 ou 5, dans lequel l'étape consistant à former l'interconnexion électrique consiste à :
- segmenter la seconde couche conductrice (65) en un premier segment de la seconde couche conductrice (65) et en un second segment de la seconde couche conductrice (65), et
- interconnecter de manière électrique le premier segment de la première couche conductrice avec le second segment de la seconde couche conductrice (65).

8. Dispositif photovoltaïque organique fabriqué selon le procédé de formation d'une interconnexion électrique dans un dispositif photovoltaïque organique selon l'une quelconque des revendications 6 ou 7, comprenant :
un substrat (60) et une chaîne de cellules solaires organiques connectées en série sur le substrat (60),
dans lequel la connexion en série des cellules solaires organiques connectées en série comprend des interconnexions électriques entre la première couche conductrice (65) d'une première cellule organique solaire et la seconde couche conductrice d'une seconde cellule organique solaire, et
dans lequel le dispositif photovoltaïque organique consiste en un dispositif de grande superficie possédant une surface supérieure à environ 25 cm².

9. Dispositif photovoltaïque organique selon la revendication 8, dans lequel la chaîne de cellules solaires organiques connectées en série comprend des terminaux électriques à ses extrémités.

10. Dispositif photovoltaïque organique selon l'une quelconque des revendications 8 ou 9, dans lequel la chaîne de cellules solaires organiques connectées en série est une première chaîne de cellules solaires organiques connectées en série, et le dispositif photovoltaïque organique comprend en outre une seconde chaîne de cellules solaires organiques électriquement connectées en parallèle à la première chaîne de cellules solaires organiques connectées en série.

11. Utilisation du dispositif photovoltaïque organique selon l'une quelconque des revendications 8 à 10 dans une fenêtre pour un bâtiment.
